# EUROPEAN PATENT SPECIFICATION

(11) **EP 2 404 755 B1**
(45) Date of publication and mention of the grant of the patent: **31.08.2016**
(21) Application number: 10748889.2
(22) Date of filing: 04.03.2010
(51) Int. Cl.: B32B 27/20, B05D 7/04, B05D 7/24, G02F 1/1333, H01L 51/10, H05B 33/02, H01L 51/00, G03F 7/09, C08J 7/04

(54) **METHOD FOR MANUFACTURING A PLANARIZING FILM**
VERFAHREN ZUR HERSTELLUNG EINER PLANARISIERUNGSSCHICHT
PROCÉDÉ DE FABRICATION D'UN FILM D'APLANISSEMENT

(30) Priority: 06.03.2009 JP 2009053461
(43) Date of publication of application: 11.01.2012
(73) Proprietor: Teijin Dupont Films Japan Limited, Chiyoda-ku Tokyo 100-0013 (JP)
(72) Inventor: ASAI, Masato, Anpachi-gun Gifu 503-0123 (JP)
(74) Representative: Cockerton, Bruce Roger
(86) International application number: PCT/JP2010/054074
(87) International publication number: WO 2010/101303

(56) References cited:
- EP-A1- 1 978 381
- WO-A1-2007/091082
- WO-A1-2009/016388
- JP-A- 2003 292 656
- JP-A- 2004 191 956
- JP-A- 2005 093 318
- JP-A- 2007 268 711

## Description

### Technical Field

The present invention relates to a method for producing a planarizing film. The planarizing film obtained by the method of the invention is suitable for a thin-film transistor substrate. In particular, the planarizing film can be suitably used for thin-film transistors (hereinafter sometimes referred to as TFTs) such as organic thin-film transistors (OTFTs), amorphous silicon transistors (a-Si TFTs), and crystal silicon transistors, as well as thin-film devices, various field display devices, electroluminescence (EL) displays, liquid crystal displays, electrochromic devices, and the like to be formed thereon.

### Background Art

In recent years, in substitution for paper as a display medium, flexible electronic display media such as electronic papers (E-papers) and flexible displays have been actively developed, and they are expected to be applied to electronic book readers, electronic newspapers, and the like. In such flexible electronic display media, devices used are required to be flexible, examples thereof including electrophoretic display devices and flexible organic EL devices. Thus, with the development of flexible devices, plastic film substrates have been used as display substrates in place of former glass substrates (Patent Documents 1 to 3). Further, for driving a flexible display, it is necessary to form TFTs or the like on a plastic film substrate to form a thin-film device (Patent Documents 4 and 5). Further, generally, a plastic film substrate has higher gas permeability than a glass substrate, causing a problem in that a thin-film device using a plastic film substrate is susceptible to deterioration. Therefore, for the purpose of preventing such deterioration, the provision of a gas barrier layer on a plastic film substrate has been considered (Patent Documents 6 and 7). Thus, in the past, various studies have been made on flexible displays.
(Patent Document 1) JP-A-2008-49695
(Patent Document 2) JP-A-11-348189
(Patent Document 3) JP-A-2007-152932
(Patent Document 4) JP-A-2007-311377
(Patent Document 5) JP-A-2008-147346
(Patent Document 6) JP-A-2005-288851
(Patent Document 7) JP-A-2006-95783

WO 2009/016388 describes a coated polyester substrate for an electronic device. WO 2007/091082 describes a method for minimizing the formation of haze in a biaxially oriented polyester film during annealing of the film above its glass transition temperature. EP 1 978 381 describes an anti-reflective film having a hard coat layer.

### Disclosure of the Invention

Meanwhile, when a TFT is directly formed on a plastic film substrate, the TFT may malfunction in some parts due to the effect of the plastic film substrate surface. A TFT includes transistor devices each corresponding to one pixel formed thereon, and the line of the source electrode or drain electrode forming such a transistor device is shared by transistor devices along the longitudinal direction or transverse direction of a screen. Therefore, when the line breaks in one transistor device, a defect occurs that all the transistor devices along the longitudinal direction or transverse direction malfunction (linear defect). In such a case, naturally, the device formed on the TFT also malfunctions, so this is a fatal flaw as a commercial product.

Therefore, a first object of the invention is to provide a production method that allows a planarizing film which, when used for a TFT substrate, is capable of suppressing linear defects even in the case where a TFT is formed directly on the film, to be obtained stably.

The planarizing film obtained by the method of the invention includes a planarizing layer containing a binder resin and an inorganic filler as constituents on at least one side of a transparent resin base. The planarizing layer is such that the number of foreign matters with an average diameter of 20 µm or more and 100 µm or less on a surface thereof is not more than 5/m².

The first object of the invention mentioned above can be achieved by a method for producing a planarizing film, including applying a coating liquid to a transparent resin base to form a planarizing layer, the coating liquid being obtained by adding at least a binder resin and an inorganic filler to a solvent, followed by mixing. The method is such that the coating liquid has a solids concentration of 25 mass% or more and 45 mass% or less, and the coating liquid is applied by gravure coating using, as a gravure roll, a gravure roll with a line frequency of 50 to 90 lpi, with the rotation ratio of the gravure roll being 60% or more and 100% or less, and then dried/cured to form a planarizing layer.

### Brief Description of the Drawings

Fig. 1 is a cross-sectional view of an example of a planarizing film obtained by the method of the invention.
Fig. 2 is a cross-sectional view of an example in which a TFT is formed on an example of a planarizing film obtained by the method of the invention.

### Explanation of Reference Numerals

- 1: Transparent resin base
- 2: Planarizing layer
- 3: Easily adhesive layer
- 4,5: Source electrode or drain electrode
- 6: Organic semiconductor layer
- 7: Insulating layer
- 8: Gate electrode
- 9: Protective layer

### Best Mode for Carrying Out the Invention

### [Planarizing Film]

A planarizing film obtained by the method of the invention includes the below-mentioned planarizing layer on at least on one side of the below-mentioned transparent resin base.

### [Transparent Resin Base]

The transparent resin base in the invention is not particularly limited. Examples thereof include sheets and films made of polyesters such as polyethylene terephthalate and polyethylene naphthalate, polyolefins such as polycarbonate, polyethylene, and polypropylene, polystyrene triacetyl cellulose, acrylic, and the like. In particular, in view of the excellent optical properties such as transparency, mechanical properties, and heat resistance, and also of the good balance between such characteristics and the price, a film made of polyester is preferable, and a film made of polyethylene terephthalate or polyethylene naphthalate is preferable. As such a film, a biaxially stretched film is preferable for even better optical properties, mechanical properties, and heat resistance.

It is preferable that the transparent resin base in the invention contains substantially no lubricant particles (e.g., preferably 40 ppm or less, more preferably 10 ppm or less, based on the mass of the transparent resin base). When substantially no lubricant particles are contained, the mode of foreign matters sought by the invention is more accessible. Further, excellent transparency is obtained.

The thickness of the transparent resin base is not particularly limited. However, in view of the excellent optical properties and handleability, the thickness is preferably 25 µm or more and 300 µm or less, still more preferably 50 µm or more and 200 µm or less, and particularly preferably 75 µm or more and 188 µm or less.

The transparent resin base in the invention may be surface-treated for the purpose of improving the adhesion to the planarizing layer, for example, by forming an easily adhesive layer thereon, applying a corona treatment thereto, etc. As such an easily adhesive layer, the anchor coat layer disclosed in JP-A-2007-216610 or JP-A-2007-206316, for example, can be mentioned as a preferred example.

### [Planarizing Layer]

The planarizing layer contains a binder resin and an inorganic filler as constituents.

The planarizing layer is provided on at least one side of the transparent resin base to compensate for flaws on the surface of the transparent resin base, such as scratches and foreign matters, thereby providing a planarizing film with a highly flat surface. For obtaining a highly flat surface at the level to be achieved by the invention, strict control of the planarizing layer formation method is important in addition to the selection of materials to form the planarizing layer. The detail will be described hereinafter.

### (Foreign Matters on Planarizing Layer Surface)

The planarizing layer in the invention is such that the number of foreign matters with an average diameter (determined as the average of four points in a foreign matter: the longest diameter, the length in the direction perpendicular to the longest diameter, and the lengths in the directions of ±45° from the longest diameter) of 20 µm or more and 100 µm or less on a surface thereof is not more than 5/m². When foreign matters on the planarizing layer surface are in such a mode, excellent flatness is obtained.
"Foreign matters" herein collectively refers to foreign matters of external origin that are incorporated in the process of the formation of the planarizing layer (application process, etc.), foreign matters from a coating liquid for forming the planarizing layer, foreign matters from the transparent resin base, and cissing defects on the planarizing layer attributable thereto. In particular, the present inventors found that in the formation of a TFT directly on the surface of the planarizing layer, when, of the above various foreign matters, the number of foreign matters with a specific average diameter (20 µm or more and 100 µm or less) is within a specific range of numbers (not more than 5/m²), the malfunction of the TFT is sufficiently suppressed. That is, the present inventors found that there is a particularly high correlation between TFT malfunction and foreign matters with a specific overage diameter, and found that by controlling the number of such foreign matters, TFT malfunction is sufficiently suppressed. The number of foreign matters is preferably not more than 4/m², still more preferably not more than 3/m², and particularly preferable not more than 2/m², whereby TFT malfunction is more suppressed. Such a mode of foreign matters cannot be attained by merely increasing the degree of cleanliness of the process. The present inventors achieved the mode for the first time by finding an optimal coating liquid for forming a planarizing layer and also finding an optimal forming method (coating process).

The following describes other preferred elements of the planarizing layer, together with the constituents forming the planarizing layer and a method for forming the same for achieving the above mode of foreign matters.

### (Center-Line-Average Surface Roughness of Planarizing Layer)

In the planarizing layer in the invention, it is preferable that the upper limit of the center-line-average surface roughness (Ra) on the surface is 10 nm or less. When Ra on the planarizing layer surface is within the above range of values, a TFT formed thereon has uniform thickness. When Ra is too large, the thickness of a TFT formed thereon tends to be non-uniform. From such a point of view, the upper limit of Ra is still more preferably 5 nm or less, and particularly preferably 2 nm or less. Meanwhile, with respect to the lower limit of Ra, a smaller value is more desirable, but the practical lower limit is 0.1 nm or more.

The above Ra can be achieved by suitably adjusting the thickness of the planarizing layer or the average particle size and content of lubricant particles in the transparent resin base. For example, the preferred ranges of values in the invention may be employed.

### (Thickness of Planarizing Layer)

The thickness of the planarizing layer in the invention is preferably 3 µm or more and 8 µm or less, still more preferably 4 µm or more and 7.5 µm or less, and particularly preferably 5 µm or more and 7 µm or less. When the thickness of the planarizing layer is within the above range of values, the flatness-improving affect can be enhanced. Further, curling can be suppressed. When the thickness is too small, it tends to be difficult to cover scratches, foreign matters, and like flaws on the transparent resin base surface, surface irregularities, or the like, and the flatness-improving effect tends to decrease. Meanwhile, when the thickness is too large, the shrinkage stress in the planarizing layer tends to be too high during heating in the process of TFT formation or the like, and the planarizing film tends to curl.

### [Constituents Forming [Planarizing Layer]

The planarizing layer in the invention contains, as mentioned above, a binder resin and an inorganic filler as constituents. In the invention, a binder resin and an inorganic filler are used together (hybridized) as constituents forming the planarizing layer. As a result, in the application of a coating liquid for forming a planarizing layer, foreign matters produced due to shearing by a coater or the like can be suppressed, whereby the average diameter of foreign matters can be reduced, and the number of foreign matters can be reduced. Further, a planarizing layer with high surface hardness and strength can be obtained.

Hereinafter, the constituents forming the planarizing layer in the invention will be described.

### (Binder Resin)

The binder resin in the invention is made mainly of a radiation-curable resin composition.

The radiation-curable resin composition is a monomer, oligomer, or polymer that is curable by radiation. The radiation-curable resin composition in the invention is preferably a polyfunctional (meth)acrylate compound, such as a polyfunctional (meth)acrylate monomer, a polyfunctional (meth)acrylate oligomer, or a polyfunctional (meth) acrylate polymer, from the point of view that the crosslinking density after curing can be increased, and higher surface hardness and strength can be achieved, whereby the flatness of the planarizing layer can be maintained, and also higher transparency can be achieved.

The polyfunctional (meth)acrylate compound is a compound having a (meth)acryloyl group in the molecule, and it is preferable that the compound has at least two (meth)acryloyl groups in the molecule. Such a structure promotes the crosslinking reaction of the radiation-curable resin composition, allowing higher surface hardness and strength. Father, accordingly, the surface shape is less likely to be deformed by external force or the like, whereby the flatness of the planarizing layer can be maintained. The polyfunctional (meth)acrylate compound in the invention may have other polymerizable functional groups in the molecule in addition to (meth)acryloyl groups.

Specific examples of polyfunctional (meth)acrylate compounds having at least two (meth)acryloyl groups in the molecule include neopentyl glycol di(meth)acrylate, trimethylol propane tri(meth)acrylate, pentaerythritol tri(meth)acrylate, trimethylolethane tri(meth)acrylate, pentaerythritol tetra(meth)acrylate, dipentaerythritol tetra(meth)acrylate, alkyl-modified dipentaerythritol tetra(meth)acrylate, dipentaerythritol penta(meth)acrylate, alkyl-modified dipentaerythritol penta(meth)acrylate, dipentaerythritol hexa(meth)acrylate, caprolactone-modified dipentaerythritol hexa(meth)acrylate, ditrimethylolpropane tetra(meth)acrylate, and melamine (meth)acrylate, as well as monomer to about 20-mer oligomers of at least one of them and polymers of at least one of them. One kind of such a polyfunctional (meth)acrylate compound may be used alone, and it is also possible to use two or more kinds together.

Such polyfunctional (meth)acrylate compounds having at least two (meth)acryloyl groups in the molecule are commercially available as Aronix M-400, M-450, M-305, M-309, M-310, M-315, M-320, TO-1200, TO-1231, TO-595, TO-756 (all manufactured by Toagosei), KAYARD D-310, D-330, DPHA, DPHA-2C (all manufactured by Nippon Kayaku), and NIKALAC MX-302 (manufactured by Sanwa Chemical), for example.

### (Photopolymerization Initiator)

Further, in the invention, in order to form a planarizing layer with better surface hardness and strength, it is preferable to use a photopolymerization initiator. Excellent surface hardness and strength allows the flatness of the planarizing layer to be maintained. Examples of photopolymerization initiators include 1-hydroxycyclohexyl phenyl ketone, 2,2-dimethoxy-2-phenylacetophenone, xanthone, fluorenone, anthraquinone, benzaldehyde, fluorene, anthraquinone, triphenylamine, carbazole, 3-methylacetophenone, 4-chlorobenzophenone, 2,2-dimethoxy-2-phenylacetophenone, 2-methyl-1-1[4-(methylthio)phenyl]-2-morpholino-propan-1-one, 2,4,6-trimethylbenzoyl diphenylphosphine oxide, and bis-(2,6-dimethoxybenzoyl)2,4,4-trimethylpentyl phosphine oxide.

The amount of the photopolymerization initiator added in the invention is preferably 0.1 mass% or more and 10 mass% or less based on the binder resin as 100 mass%. When the amount added is within the above range of values, higher surface hardness and strength can be achieved. Further, the maintenance of the flatness of the planarizing layer is facilitated. When the amount added is too large, the photopolymerization initiator added tends to act as a plasticizer, whereby the flatness-improving effect of the planarizing layer may decrease. Further, the surface hardness and strength may decrease.

### (Inorganic Filler)

The planarizing layer in the invention contains an inorganic filler for the purpose of reducing the average diameter or number of foreign matters on the surface of the planarizing layer, for the purpose of increasing flatness, for the purpose of increasing surface hardness and strength, for the purpose of increasing transparency, or for the purpose of suppressing curling.

Such an inorganic filler is preferably a silicon oxide or an aluminum oxide, and this allows the average diameter and number of foreign matters on the planarizing layer surface to be smaller, allowing higher flatness. Further, higher transparency can be achieved. In particular, silicon oxides are preferable, and this allows the average diameter and number of foreign matters on the planarizing layer surface to be particularly small, allowing particularly high flatness.

In the invention, the above inorganic filler can be added to reduce the average diameter and number of foreign matters on the planarizing layer surface, thereby increasing flatness. However, an inorganic filler that will not affect optical properties necessary as the planarizing film should be selected. For example, an inorganic filler having an average particle size and a refractive index within specific ranges of values is preferably used.

For the above purposes, in the invention, the average particle size of the inorganic filler is preferably 2 nm or more and 2000 nm or less. When the average particle size is within the above range of values, this allows the average diameter and number of foreign matters to be smaller, flatness to be higher, and surface hardness and strength to be higher, while maintaining the transparency of the planarizing layer. When the average particle size of the inorganic filler is too large, transparency tends to decrease. Further, the average diameter or number of foreign matters is likely to increase. Meanwhile, when it is too small, the strength of the inorganic filler itself tends to decrease, and the surface hardness and strength tends to decrease. Further, the flatness-improving effect tends to decrease. From such a point of view, the average particle size of the inorganic filler is still more preferably 3 nm or more and 200 nm or less, and particularly preferably 5 nm or more and 100 nm or less.

Further, it is preferable to use an inorganic filler having a specific refractive index, and inorganic fillers whose refractive index difference from the binder resin is less than 0.1 are preferable. In the case where the refractive index difference is within the above range of values, the transparency of the planarizing layer can be more easily maintained even when the inorganic filler is added. Therefore, the preferred average particle size and content can be more easily achieved, allowing the average diameter and number of foreign matters to be smaller, flatness to be higher, and surface hardness and strength to be higher. When the refractive index difference is too large, transparency tends to decrease. From such a point of view, the refractive index difference is preferably less than 0.08, and still more preferably less than 0.06.

Further, the inorganic filler content is preferably 10 mass% or more and 250 mass% or less based on the binder resin as 100 mass%. When the content is within the above range of values, this allows the average diameter and number of foreign matters to be smaller, flatness to be higher, and surface hardness and strength be higher, while maintaining the transparency of the planarizing layer. When the content is too large, the average diameter and number of foreign matters are likely to increase. Further, transparency tends to decrease. When the content is too small, the flatness-improving effect tends to decrease. Further, the surface hardness and strength tends to decrease. From such a point of view, the content is still more preferably 20 mass% or more and 150 mass% or less, particularly preferably 40 mass% or more and 100 mass% or less, based on the binder resin as 100 mass%.

One kind of such an inorganic filler may be used alone, and it is also possible to use two or more kinds in combination.

In the invention, it is preferable to use an inorganic filler in the form of a powder or a solvent dispersion sol obtained by dispersing a powder inorganic filler in a solvent to form a sol. When the inorganic filler is in the form of a solvent dispersion sol, the dispersion medium is preferably an organic solvent from the point of view that the compatibility with the binder resin is improved. Examples of organic solvents include alcohols such as methanol, ethanol, isopropanol, and butanol; ketones such as acetone, methyl ethyl ketone, methyl isobutyl ketone, and cyclohexanone; esters such as ethyl acetate, butyl acetate, propylene glycol monomethyl ether acetate, and propylene glycol monoethyl ether acetate; ethers such as propylene glycol monomethyl ether and propylene glycol monomethyl ether; and aromatic hydrocarbons such as benzene, toluene, and xylene. In particular, methanol, isopropanol, butanol, methyl ethyl ketone, methyl isobutyl ketone, ethyl acetate, butyl acetate, toluene, and xylene are preferable, whereby excellent compatibility is obtained. Further, in order to improve the dispersibility of the inorganic filler, various surfactants, amines, and the like can be added.

As such inorganic fillers, for example, silicon oxides in the form of solvent dispersion sols are commercially available as IPA-ST, MEK-ST, NBA-ST, XBA-ST, DMAC-ST, ST-UP, ST-OUP, ST-20, ST-40 (all manufactured by Nissan Chemical Industries), et., and they can preferably be used. Further, aluminum oxides in the form of solvent dispersion sols are commercially available as ALUMINASOL-100, ALUMINASOL-200, ALUMINASOL-500 (all manufactured by Nissan Chemical Industries), AS-150I, AS-150T (all manufactured by Sumitomo Osaka Clement), etc., and they can preferably be used.

Further, the inorganic filler in the invention is preferably surface-treated with a polymerizable surface-treating agent for the purpose of improving dispersibility in the binder resin, for the purpose of achieving a well dispersed state in the planarizing layer, or for the purpose of forming a crosslinking point with the binder resin to improve the surface hardness and strength of the planarizing layer.

As such a surface-treating agent, for example, a compound that contains a silanol group or forms a silanol group by hydrolysis is mentioned (hereinafter sometimes referred to as a silane coupling agent), and is preferably used. Further, a silane coupling agent containing a silanol group and a polymerizable functional group other than the silanol group is preferable. The silanol group in such a silane coupling agent can undergo a crosslinking reaction with a hydroxy group present on the surface of the inorganic filler by heat or the like, whereby the silane coupling agent bonds to the surface of the inorganic filler, and the dispersibility in the organic component can be increased. Examples of polymerizable functional groups other than a silanol group include an acryloyl group, a methacryloyl group, a vinyl group, a propenyl group, a butadienyl group, a styryl group, an ethynyl group, an acrylamide group, and a hydroxy group.

Such silane coupling agents are commercially available as TSL-8350, TSL-8337, TSL-8370, TSL-8375 (all manufactured by GE Toshiba Silicones), A-9530 (manufactured by Shin-Nakamura Chemical), and A-187 (manufactured by Nippon Unicar), for example, and they can preferably be used.

The method for obtaining a surface-treated inorganic filler is not particularly limited, and it may be obtained by the following method, for example. That is, the above silane coupling agent is mixed with an inorganic filler, ionexchange water is further added thereto, and the mixture is then allowed to stand at room temperature to promote the hydrolysis of the silane coupling agent. The time necessary for hydrolysis depends on the substances used, and is usually about 1 hour to about 24 hours. After the hydrolysis of the silane coupling agent has sufficiently proceeded, a temperature of 20°C to 150°C is applied to allow silanol groups in the silane coupling agent to react with hydroxy groups on the surface of the inorganic filler. A surface-treated inorganic filler can thus be obtained.

### (Other Additives)

The planarizing layer in the invention may further contain, in addition to those mentioned above, photosensitizers, leveling agents, lubricants, plasticizers, UV absorbers, antioxidants, antistatic agents, pigments, dyes, and the like to the extent that they do not interfere with the objects of the invention.

### [Method for Forming Planarizing Layer]

The planarizing film can be obtained by applying a coating liquid for forming a planarizing layer (hereinafter sometimes referred to simply as coating liquid) to the surface of the transparent resin base, on which a planarizing layer is to be formed, followed by heat-drying and curing.

The following describes a production method that is particularly preferable to satisfy the mode of foreign matters sought by the invention.

### (Coating Liquid for Forming Planarizing Layer)

The coating liquid for forming the planarizing layer in the invention is a solution obtained by adding a binder resin, an inorganic filler, an optional photopolymerization initiator, and optional other additives to a solvent, followed by mixing. In the addition of each component, the component may be added in the form of a solid such as a powder, or may also be added in the form of a solution using an appropriate solvent or a dispersion element. The solvent used for the coating liquid is not particularly limited as long as it is satisfactory in terms of binder resin solubility and inorganic filler dispersibility, and ordinary organic solvents are usable. For example, ketones such as methyl ethyl ketone, methyl isobutyl ketone, and cyclohexanone, alcohols such as methanol, ethanol, propanol, n-butanol, secondary butanol, t-butanol, and isopropyl alcohol, esters such as butyl acetate and ethyl acetate, aromatic hydrocarbons such as toluene and xylene, and glycol ethers such as propylene glycol monomethyl ether and propylene glycol monomethyl ether acetate are usable, whereby the dispersibility of the coating liquid is improved, and the appearance of the planarizing layer is improved. In particular, in view of the excellent solubility, ketones are preferable, and methyl ethyl ketone and methyl isobutyl ketone are particularly preferable.

The solids concentration of the coating liquid is 2 5 mass% or more and 45 mass% or less. When the solids concentration of the coating liquid is within the above range of values, the average diameter and number of foreign matters on the planarizing layer surface can be reduced. When the solids concentration is too low, the content of the diluting solvent in the coating liquid is too high, whereby the dispersed state of the inorganic filler in the coating liquid is likely to be destroyed, aggregates are likely to be formed, and the average diameter and number of foreign matters on the planarizing layer surface tend to increase. Meanwhile, when the solids concentration is too high, the coating liquid viscosity is too high, whereby gel-like foreign matters are likely to be formed due to shear during application, and the average diameter and number of foreign matters on the planarizing layer surface tend to increase. From such a point of view, the solids concentration of the coating liquid is preferably 30 mass% or more and 42 mass% or less, and particularly preferably 35 mass% or more and 40 mass% or less.

### (Method for Applying Coating Liquid for Forming Planarizing Layer)

In the invention, when the coating liquid for forming a planarizing layer is applied, a known method can be employed as the application method. In particular, a gravure roll coater method (gravure coating) is used. In the invention, reverse gravure coating is especially preferable, and small-diameter reverse gravure coating (this refers to, for example, coating using a micro-gravure coater manufactured by Yasui Seiki, etc., and "small-diameter" refers to a diameter of about 100 mm or less, and preferably 80 mm or less) is particularly preferable, whereby the average diameter and number of foreign matters on the surface of the planarizing layer can be reduced.

As a gravure roll used for application, it is neccessary to use one with a line frequency of 50 to 90 lpi. Line frequency herein refers to the number of depressions in the gravure engraving in a length of 1 inch. When a gravure roll with a line frequency within the above-mentioned range is used, the average diameter and number of foreign matters on the planarizing layer surface can be reduced to achieve the mode sought by the invention. When the coating liquid is applied using a gravure roll where the line frequency is too low, in the case where, for example, the preferable thickness mentioned above is to be achieved, the concentration of the coating liquid tends to be too low. Accordingly, for the same reason as when the solids concentration of the coating liquid is too low, the average diameter and number of foreign matters on the planarizing layer surface increase. Meanwhile, when the coating liquid is applied using a gravure roll where the line frequency is too high, the shear stress applied on the coating liquid per unit area tends to be too high, and gel-like foreign matters are likely to be formed, whereby the average diameter and number of foreign matters on the planarizing layer surface tend to increase. From such a point of view, as a gravure roll, one with a line frequency of 60 to 80 lpi is particularly preferable.

Further, in the invention, it is necessary that the rotation ratio of the gravure roll (ratio of the rotational speed of the gravure roll (unit: m /min) to the line speed (web speed of the transparent resin base) (unit: m /min)) (unit: %) is 60% or more and 100% or less. When the rotation ratio of the gravure roll is within the above-mentioned range, the average diameter and number of foreign matters on the planarizing layer surface can be reduced to achieve the mode sought by the invention. When the rotation ratio is too low, shear tends to be applied to the coating liquid for a longer period of time, and the foreign matters in the coating liquid tend to increase, whereby the average diameter and number of foreign matters on the planarizing layer surface tend to increase. Meanwhile, when the rotation ratio is too high, the coating liquid tends to be subjected to higher shear, and the foreign matters in the coating liquid tend to increase, whereby the average diameter and number of foreign matters on the planarizing layer surface tend to increase. From such a point of view, the rotation ratio of the gravure roll is preferably 60% or more and 80% or less.

As mentioned above, the coating liquid is applied onto the transparent resin base to form a coating film, and then the obtained coating film is heat-dried. With respect to the heat-drying conditions, heating is performed preferably at 50 to 150°C for 10 to 150 seconds, still more preferably at 50 to 120°C for 20 to 130 seconds, and particularly preferably at 50 to 80°C for 30 to 120 seconds. After heat-drying, the coating film is cured by UV irradiation or electron beam irradiation. In the case of UV irradiation, the dose is preferably 10 to 2000 mJ/cm², still more preferably 50 to 1500 mJ/cm², and particularly preferably 100 to 1000 mJ/cm², whereby the surface-hardness-improving effect can be further enhanced.

Thus, a planarizing film, in which a planarizing layer that satisfies the mode of foreign matters sought by the invention is formed on a transparent resin base, can be obtained.

### Examples

Hereinafter, the invention will be described in further detail through examples. Evaluations in the Examples were made according to the following methods.

### (1) Thickness of Planarizing Layer

A planarizing film was cut with a sharp razor, and the resulting cross section was observed under an optical microscope to measure the thickness of the planarizing layer. The measurement was performed at arbitrary 10 points, and their average was taken as the thickness of the planarizing layer (unit: **µ**m).

### (2) Curl Measurement

A planarizing film was cut into a size of 10 cm x 10 cm, and heat-treated at a temperature of 120°C for 30 minutes. The heat-treated sample was allowed to stand on a horizontal flat desk in such a manner that the curl was convex downward, and the height of the edge above the surface of the desk was measured. Five samples were subjected to measurement, and their average was taken as the curl (unit: mm). Besides, the part highest above the surface of the desk was used as the height of the edge.

### (3) Average Diameter and Number of Foreign Matters on Planarizing Layer Surface

A planarizing film was cut into a size of 1 m x 1 m. A three-band fluorescent lamp was placed 15 cm above the planarizing layer of the planarizing film so that the illuminance on the surface of the planarizing film was 2000 lx or more. The planarizing layer surface was observed under such conditions, and visually recognizable foreign matters were marked. Marked foreign matters were observed under a microscope, and the average diameter of foreign matters was determined by the following method. That is, the average of four points of a foreign matter, the longest diameter, the length in the direction perpendicular to the longest diameter, and the lengths in the directions of ±45° from the longest diameter, was determined as the average diameter (unit: µm). The measurement was performed on all the foreign matters marked above. The number of foreign matters with an average diameter of 20 µm or more and 100 µm or less was counted, and the number of foreign matters per unit was determined (unit: the number of foreign matters/m²).

It is said that the size of a foreign matter recognizable by the naked eye is generally 50 **µ**m or more. However, it was confirmed that in the planarizing film obtained by the method of the invention, because of the lens effects around foreign matters, foreign matters with an actual size of about 15 **µ**m can also be visually detected.

### (4) Thin-Film Transistor (TFT) Defect Rate

TFT devices were formed on the planarizing layer of a planarizing film by the below-mentioned method. Subsequently, with respect to the formed TFT devices, the operating characteristics of a p-channel enhancement-mode FET were evaluated, and the ON/OFF ratio of each transistor device (the drain current ratio at a drain bias of -40V with the gate bias being -50V and 0V) was determined. When the ON/OFF ratio was 10² or less, the device was considered not functioning. The total number of devices was divided by the number of non-functioning devices, and the proportion was defined as the defect rate (unit:%). A defect rate of 0.1% or less is desirable.

### Example 1

### <Preparation of Coating Liquid for Forming Easily Adhesive Layer>

Polyester: A polyester having an acid component including 65 mol% 2,6-naphthalene dicarboxylic acid/30 mol% isophthalic acid/5 mol% 5-sodium sulfoisophthalic acid and a glycol component including 90 mol% ethylene glycol/10 mol% diethylene glycol was used (Tg = 80°C, number-average molecular weight: 13000).

The polyester was produced as follows according to the method described in JP-A-6-116487, Example 1. That is, 100 parts of dimethyl 2,6-naphthalenedicarboxylate, 37 parts of dimethyl isophthalate, 9 parts of dimethyl 5-sodium sulfoisophthalate, 75 parts of ethylene glycol, and 6 parts of diethylene glycol were charged into a reactor, and 0.05 parts of tetrabutoxytitanium was added thereto. The mixture was heated in a nitrogen atmosphere at a controlled temperature of 230°C to effect an ester exchange reaction while distilling off the formed methanol. Subsequently, the temperature of the reaction system was slowly raised to 255°C, and the pressure in the system was reduced to 1 mmHg to effect a polycondensation reaction, thereby giving the polyester.

Using tetrahydrofuran as a solution, in the usual manner, the obtained polyester was used as a water dispersion (solids concentration: 15 mass%).

Acrylic: An acrylic including 30 mol% methyl methacrylate/30 mol% 2-isopropenyl-2-oxazoline/10 mol% polyethylene oxide (n= 10) methacrylate/30 mol% acrylamide was used (Tg: 50°C).

The acrylic was produced as follows according to the method described in JP-A-63-37167, Production Examples 1 to 3. That is, 3 parts of sodium lauryl sulfonate as a surfactant and 181 parts of ion exchange water were charged into a four-necked flask, and the temperature was raised to 60°C in a nitrogen gas stream. Subsequently, as polymerization initiators, 0.5 parts of ammonium persulfate and 0.2 parts of podium hydrogen nitrite were added thereto. Further, a mixture of 23.3 parts of methyl methacrylate, 22.6 parts of 2-isopropenyl-2-oxazoline, 40.7 parts of polyethylene oxide (n= 10) methacrylate, and 13.3 parts of acrylamide, which are monomers, was added dropwise over 3 hours while adjusting the liquid temperature at 60 to 70°C. After the completion of dropwise addition, while maintaining the above temperature range for 2 hours, the reaction was allowed to continue with stirring. Cooling was then performed to give an acrylic water dispersion (solids concentration: 35 mass%).

Addictive: A silica filler (average particle size: 100 nm) (manufactured by Nissan Chemical Industries, trade name: Snowtex ZL) was used.

Wetting agent: Polyoxyethylene (n= 7) lauryl ether (manufactured by Sanyo Chemical Industries, trade name: NAROACTY N-70) was used.

The materials obtained above were blended in the following solids ratio: 60 mass% polyester, 30 mass% acrylic, 5 mass% additive, 5 mass% wetting agent. The mixture was thoroughly stirred, and then diluted with ionexchange water to a solids concentration of 8 mass%. A coating liquid for forming an easily adhesive layer was thus prepared.

### <Formation of Transparent Resin Base and Easily Adhesive Layer>

Molten polyethylene terephthalate ([η = 0.62 dl/g (25°C, orthochlorophenol), Tg = 78°C) was extruded from a die, and cooled on a cooling drum in the usual manner to give an unstretched film. Subsequently, the unstretched film was stretched 3.4 times the original length in the longitudinal direction to give a longitudinally uniaxially stretched film. Then, the above-obtained coating liquid for forming an easily adhesive layer was uniformly applied to both sides of the obtained longitudinally uniaxially stretched film using a roll coater. Subsequently, the film was stretched 3.6 times the original length in the transverse direction at 125°C, and heat-set at 220°C while allowing 3% shrinkage in the width direction to give a 188-µm-thick transparent resin base having an easily adhesive layer. The thickness of the easily adhesive layer was 0.04 µm.

### <Coating Liquid for Forming Planarizing Layer>

A coating agent containing, as main components, a binder resin made of dipentaerythritol hexa(meth)acrylate as a main component (refractive index: 1.53) and a silicon oxide to serve as an inorganic filler (surface-treated with a silane coupling agent, average particle size: 20 nm, refractive index: 1.47) (manufactured by JSR Corporation, trade name: Z7501, refractive index after drying: 1.51, the solids mass ratio between the binder resin and the inorganic filler: 60:40) was diluted with methyl ethyl ketone (MEK) to a solids concentration of 37.5 mass%. A silicone oil (manufactured by Shin-Etsu Chemical, trade name: KP-341) was added thereto as a leveling agent to be 0.12 mass% relative to the solids content of the coating liquid. A coating liquid for forming a planarizing layer was thus obtained.

### <Formation of Planarizing Layer>

Using a micro-gravure coater manufactured by Yasui Seiki (gravure roll line frequency: 70 lpi, diameter: 50 mm), the above-obtained coating liquid for forming a planarizing layer was uniformly applied by reverse gravure coating to one surface of the transparent resin base having the easily adhesive layer in such a manner that the film thickness after drying/curing would be 6 µm. At this time, the ratio of the rotational speed of the gravure roll to the line speed (rotation ratio of the gravure roll) was set at 70%. Subsequently, after drying at 70°C for 2 minutes, UV irradiation was performed using a UV irradiation apparatus (manufactured by Fusion UV Systems Japan, trade name: Fusion H Bulb) at a light intensity of 200 mJ/cm². A planarizing film having a planarizing layer formed on the transparent resin base was thus formed.

Table 1 shows the characteristics of the thusobtained planarizing film and planarizing layer.

### <Formation of Thin-Film Transistor (TFT)>

Subsequently, on the planarizing layer of the above-obtained planarizing film, a top-gate organic TFT was formed by the following method. The substrate size was 12 cm x 12 cm, and 500 x 500 organic TFT devices were formed in a 10 cm x 10 cm region thereof (assumed pixel pitch: 200 µm).

### 1. Formation of Source/Drain electrodes

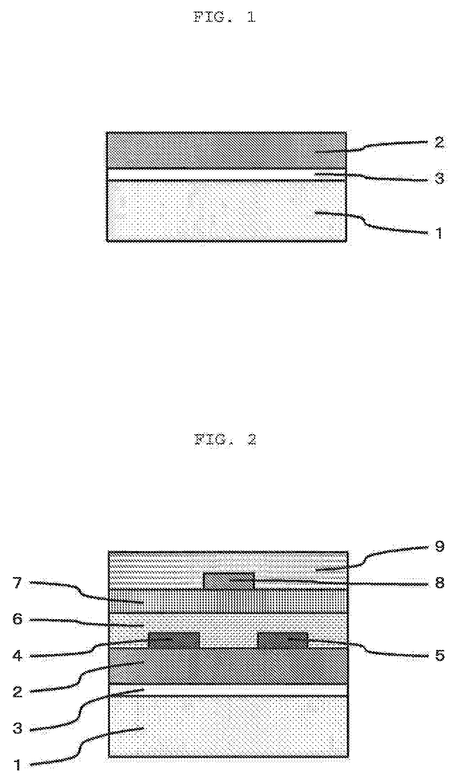

A 50-nm-thick copper film was formed on the planarizing layer (reference numeral 2 in Fig. 2) of the Planarizing film by spluttering, and a commercially available photosensitive resist material was applied thereover and dried to form a 2-µm-thick photosensitive resist layer. Then, using a semiconductor laser with a wavelength of 830 nm and an output of 100 mW, the photosensitive resist layer was irradiated at an energy intensity of 200 mJ/cm² to expose the path lines of the source/drain electrodes, followed by development with an aqueous alkali solution to give a resist image. Then, copper of unnecessary portions was dissolved away with dilute sulfuric acid/dilute nitric acid, and the remaining resist was entirely subjected to exposure/alkali removal to give source/drain electrode patterns (reference numeral 4 or 5 in Fig. 2). The width of the source/drain electrodes was 40 µm, and the width of the path line was 30 µ.

### 2. Formation of Organic Semiconductor Layer

A toluene solution of pentacene (1.0%) was added dropwise onto the substrate having formed therein the above source/drain electrode patterns while heating to 60°C on a hot plate in a nitrogen atmosphere. An organic semiconductor layer (reference numeral 6 in Fig. 2) was thus formed (200 nm thick).

### 3. Formation of Insulating Layer

First, polystyrene (PS): manufactured by Aldrich Corporation (weight-average molecular weight Mw = 280000 (according to GPC method)) was dissolved in toluene to a concentration of 5%, and filtered through a 0.45-µm filter. Subsequently, the PS solution was spread on the organic semiconductor layer formed in the step 2 above, applied by spin coating at 3000 rpm for 120 seconds, and then dried in a vacuum at a temperature of 90°C for 30 minutes. An insulating layer (reference numeral 7 in Fig. 2) was thus obtained.

### 4. Formation of Gate Electrode

With respect to the planarizing film having formed thereon the insulating layer and so forth, aluminum was deposited onto the insulating layer using a mask for patterning. A gate electrode (reference numeral 8 in Fig. 2) was thus formed.

### 5. Preparation of Protective Layer

Leaving a contact to the gate electrode using a mask, SiOₓN_{y} was sputtered to form a protective layer (numeral 9 in Fig. 2).

The characteristics of the thus-obtained TFT are shown in Table 1.

### Example 2

An organic TFT was formed in the same manner as in Example 1, except that the source/drain electrodes were made of gold. In this example, aqua regia was used as the etching liquid. Table 1 shows the characteristics of the Planarizing film and Planarizing layer used and the TFT obtained.

### Example 3

A planarizing film and a TFT were formed in the same manner as in Example 1, except that the rotation ratio of the gravure roll in the formation of a Planarizing layer was 100%. Table 1 shows the characteristics of the obtained planarizing film, planarizing layer, and TFT.

### Comparative Example 1

A planarizing film and a TFT were formed in the same manner as in Example 1, except that a coating agent containing an acrylic composition as a binder resin and not containing an inorganic filler (manufactured by Dainichiseika Color & Chemicals Mfg., EXF-D202) (solids concentration: 70 mass%) was used in replace of the product of JSR Corporation, trade name: Z7501. Table 1 shows the characteristics of the obtained planarizing film, planarizing layer, and TFT.

### Comparative Example 2

A planarizing film and a TFT was formed in the same manner as in Example 1, except that the rotation ratio of the gravure roll in the formation of a planarizing layer was 40%. Table 1 shows the characteristics of the obtained planarizing film, planarizing layer, and TFT.

### Comparative Example 3

A planarizing film and a TFT were formed in the same manner as in Example 1, except that the solids concentration of the coating liquid for forming a planarizing layer was 20 mass%. Table 1 shows the characteristics of the obtained planarizing film, planarizing layer, and TFT.

These results show that only when the requirements of the invention are satisfied, a TFT directly formed on a planarizing layer has a low defect rate.

**Table 1**

| | Application Conditions | | Planarizing Film | | | Thin-Film Transistor |
|---|---|---|---|---|---|---|
| | | | Planarizing Layer | | | |
| | Solids concentration of coating liquid for forming planarizing layer | Rotation ratio of gravure roll | Thickness | Number of foreign matters with an average diameter of 20 µm or more and 100 µm or less | Curl | Defect rate |
| Unit | mass% | % | µm | the number of foreign matters/m² | mm | % |
| Example 1 | 37.5 | 70 | 6 | 2 | 10 | 0.03 |
| Example 2 | 37.5 | 70 | 6 | 2 | 10 | 0.05 |
| Example 3 | 37.5 | 100 | 8.5 | 5 | 20 | 0.06 |
| Comparative Example 1 | 37.5 | 70 | 6 | 10 | 10 | 0.5 |
| Comparative Example 2 | 37.5 | 40 | 4 | 16 | 5 | 0.7 |
| Comparative Example 3 | 20 | 70 | 3 | 20 | 3 | 1.0 |

### Advantage of the Invention

The invention makes it possible to provide a planarizing film with fewer flaws. Further, the invention makes it possible to provide a planarizing film which, when used for a thin-film transistor (TFT) substrate, is capable of suitably suppressing TFT malfunction even in the case where a TFT is directly formed on the film, thereby suppressing linear defects. Therefore, the planarizing film obtained by the method of the invention is particularly suitable for a TFT substrate.

### Industrial Applicability

The planarizing film obtained by the method of the invention has a suppressed number of foreign matters with a specific average diameter, and has fewer flaws together with excellent flatness. Therefore, when the planarizing film is used for a thin-film transistor (TFT) substrate, even in the case where a TFT is directly formed on the film, the malfunction of the TFT can be sufficiently suppressed. Further, accordingly, linear defects can be suppressed. Thus, the planarizing film obtained by the method of the invention is particularly suitable for a TFT substrate. In particular, the planarizing film can be suitably used for TFTs such as organic thin-film transistors, amorphous silicon transistors, and crystal silicon transistors, as well as thin-film devices, various field display devices, electroluminescence (EL) displays, liquid crystal displays, electrochromic devices, and the like to be formed thereon.

## Claims

1. A method for producing a planarizing film, comprising applying a coating liquid to a transparent resin base to form a planarizing layer, the planarizing layer being such that the number of foreign matters with an average diameter of 20 µm or more and 100 µm or less on a surface thereof is not more than 5/m²; the coating liquid being obtained by adding at least a binder resin and an inorganic filler to a solvent, followed by mixing,
the method being such that the coating liquid has a solids concentration of 25 mass% or more and 45 mass% or less, and the coating liquid is applied by gravure coating using, as a gravure roll, a gravure roll with a line frequency of 50 to 90 lpi, with the rotation ratio of the gravure roll being 60% or more and 100% or less, and then dried/cured to form a planarizing layer.

## Patentansprüche

1. Verfahren zur Herstellung eines Planarisierungsfilms, umfassend das Aufbringen einer Beschichtungsflüssigkeit auf eine transparente Harzgrundlage zur Bildung einer Planarisierungsschicht, wobei die Planarisierungsschicht so beschaffen ist, dass die Zahl von Fremdstoffen mit einem mittleren Durchmesser von 20 µm oder mehr und 100 µm oder weniger auf einer Oberfläche davon höchstens 5/m² beträgt; wobei die Beschichtungsflüssigkeit durch Zugeben mindestens eines Bindemittelharzes und eines anorganischen Füllstoffs zu einem Lösungsmittel und anschließendes Mischen erhalten wird,
wobei das Verfahren so beschaffen ist, dass die Beschichtungsflüssigkeit eine Feststoffkonzentration von 25 Massen-% oder mehr und 45 Massen-% oder weniger aufweist und die Beschichtungsflüssigkeit durch Tiefdruckbeschichtung aufgebracht wird, wobei als Tiefdruckwalze eine Tiefdruckwalze mit einer Linienfrequenz von 50 bis 90 lpi verwendet wird, wobei das Rotationsverhältnis der Tiefdruckwalze 60% oder mehr und 100% oder weniger beträgt, und dann zur Bildung einer Planarisierungsschicht getrocknet/gehärtet wird.

## Revendications

1. Procédé de production d'un film de planarisation, comprenant l'application d'un liquide de couchage sur une base en résine transparente afin de former une couche de planarisation, la couche de planarisation étant telle que le nombre de corps étrangers présentant un diamètre moyen de 20 µm ou plus et 100 µm ou moins sur une surface de celle-ci est d'au plus 5/m²; le liquide de couchage étant obtenu par ajout d'au moins une résine agglomérante et d'une charge minérale à un solvant, puis mélange,
le procédé étant tel que le liquide de couchage présente une teneur en matière sèche de 25 % en masse ou plus et 45 % en masse ou moins, et le liquide de couchage est appliqué par couchage par gravure en utilisant, en tant que cylindre gravé, un cylindre gravé présentant une linéature de 50 à 90 lpi, le taux de rotation du cylindre gravé étant de 60 % ou plus et 100 % ou moins, et ensuite séché/durci afin de former une couche de planarisation.
